# EUROPEAN PATENT APPLICATION

(11) **EP 4 821 678 A1**
(43) Date of publication of application: **14.10.2026**
(21) Application number: 24900665.1
(22) Date of filing: 05.12.2024
(51) Int. Cl.: B32B 25/20, B32B 25/10, C08L 83/05, C08L 83/07, H01L 23/373

(54) **THERMALLY CONDUCTIVE SILICONE COMPOSITE SHEET**

(30) Priority: 06.12.2023 JP 2023206111
(71) Applicant: SHIN-ETSU CHEMICAL CO., LTD., Tokyo 100-0005 (JP)
(72) Inventor: ITO Takanori, Annaka-shi, Gunma 379-0224 (JP); SAKURAI Yuuki, Annaka-shi, Gunma 379-0224 (JP); MIYANO Megumi, Annaka-shi, Gunma 379-0224 (JP); ENDO Akihiro, Annaka-shi, Gunma 379-0224 (JP); TSUKADA Junichi, Annaka-shi, Gunma 379-0224 (JP); ISHIHARA Yasuhisa, Tokyo 100-0005 (JP)
(74) Representative: Angerhausen, Christoph
(86) International application number: PCT/JP2024/043029
(87) International publication number: WO 2025/121372

(57) **Abstract**

Provided is a thermally conductive silicone composite sheet including a high-hardness thermally conductive silicone layer and a low-hardness thermally conductive silicone layer laminated in a good adhesion state. The thermally conductive silicone composite sheet includes a support layer (X), a high-hardness thermally conductive silicone rubber layer (Y), and a low-hardness thermally conductive silicone rubber layer (Z) laminated in this order. The support layer (X) is obtained by filling a mesh reinforcement with a cured product of a thermally conductive composition. The high-hardness thermally conductive silicone rubber layer (Y) and the low-hardness thermally conductive silicone rubber layer (Z) are each a cured product of an addition-curable silicone rubber composition.

## Description

### Technical Field

The present invention relates to a thermally conductive silicone composite sheet.

### Background Art

As a material for the purpose of releasing heat of electronic components and the like, a thermally conductive silicone composite sheet including a high-hardness thermally conductive silicone rubber layer (high-hardness layer) and a low-hardness thermally conductive silicone rubber layer (low-hardness layer) is known. The high-hardness layer is excellent in handling, but has a problem that high stress is generated when the layer is fixed between a heat-generating member and a cooling member. Meanwhile, in the low-hardness layer, since a high stress is not applied to a heat-generating element and adhesion is also good, the thermal contact resistance is low. However, its low hardness makes handling difficult, and deformation occurs easily. A composite sheet obtained by laminating these layers exhibits excellent handling properties and does not impose excessive stress on a heat-generating member. Furthermore, it is also known that the handling and strength are improved by reinforcing the high-hardness layer with glass cloth or the like (Patent document 1).

However, since the high-hardness layer is formed by a peroxide vulcanization system and the low-hardness layer is formed by an addition vulcanization system, the affinity between both layers is poor. Accordingly, considerable primer treatment is required for improving the adhesion between the both, and even if the adhesion between the both is improved, there is a problem with its reliability such as oil bleeding from the low-hardness layer. A measure for addressing this issue includes applying an uncured low-hardness layer onto an uncured high-hardness layer and curing the two simultaneously. This approach is also known to provide sufficient adhesion between the layers without primer treatment (Patent Document 2).

However, forming the high-hardness layer requires the use of a release-treated resin film as a base material. After molding, this base material must be peeled off, and although fluorine-based release agents provide excellent releasability, their use is increasingly restricted by recent environmental regulations. In addition, because the base material has a mirror-finished surface, tack remains after curing of the high-hardness layer. As a result, the thermally conductive silicone composite sheet exhibits tack on both the high-hardness layer and the low-hardness layer, which can reduce workability during use, for example, during positioning.

On the other hand, a method is known in which a mesh reinforcement filled with a thermally conductive material is interposed between the high-hardness layer and the low-hardness layer, thereby providing a thermally conductive silicone composite sheet with improved adhesion through an anchor effect (Patent Document 3). However, increasing the blending amount of the thermally conductive filler in the low-hardness layer impairs its flexibility, making it difficult to achieve good adhesion between the low-hardness layer and the high-hardness layer. Furthermore, because the low-hardness layer is a thin film with a thickness of 0.015 to 0.2 mm, the compression stress increases, making it difficult to use the low-hardness layer under high compression.

### Prior Art Documents

### Patent documents

Patent document 1: JP-A-H06-155517
Patent document 2: JP-A-2021-089908
Patent document 3: JP-A-2014-193598

### Summary of Invention

### Technical Problem

The present invention has been made to solve the above problems, and it is an object to provide a thermally conductive silicone composite sheet in which a high-hardness thermally conductive silicone rubber layer and a low-hardness thermally conductive silicone rubber layer are laminated in a good adhesion state. Another object is to suppress oil bleeding from this composite sheet. A further object is to eliminate the need for a resin film that would otherwise be required when molding it into a sheet-shaped silicone.

### Solution to Problem

The present inventors have intensively studied to solve the above problems and, as a result, have found that the following thermally conductive silicone composite sheet can achieve the above objects, and the present invention has been accomplished.

That is, the present invention provides the thermally conductive silicone composite sheet as defined below.
<1> A thermally conductive silicone composite sheet comprising, laminated in the following order:
   a support layer (X),
   a high-hardness thermally conductive silicone rubber layer (Y), and
   a low-hardness thermally conductive silicone rubber layer (Z),
   wherein the support layer (X) is composed of a mesh reinforcement filled with a cured product of a thermally conductive composition, and
   wherein the high-hardness thermally conductive silicone rubber layer (Y) and the low-hardness thermally conductive silicone rubber layer (Z) are each a cured product of an addition-curable silicone rubber composition, and the high-hardness thermally conductive silicone rubber layer (Y) has a hardness of 50 to 97 as measured by a method described in JIS K6253-1: 2012 using a Shore A hardness tester, and the low-hardness thermally conductive silicone rubber layer (Z) has a hardness of 2 to 30 as measured by a method described in JIS K7312: 1996 using an Asker C hardness tester.
<2> The thermally conductive silicone composite sheet according to <1>, wherein the mesh reinforcement is glass cloth.
<3> The thermally conductive silicone composite sheet according to <1> or <2>, wherein the high-hardness thermally conductive silicone rubber layer (Y) is a cured product of an addition-curable silicone rubber composition comprising the components (A1) to (D1) defined as:
   (A1) an organopolysiloxane containing two or more alkenyl groups per molecule and having an average polymerization degree of 100 to 20,000 in an amount of 100 parts by mass;
   (B1) an organohydrogen polysiloxane containing two or more hydrosilyl groups per molecule in an amount such that a ratio of the number of moles of hydrosilyl groups in the component (B1) to the number of moles of alkenyl groups in the component (A1) is 1.0 to 3.5;
   (C1) a platinum-group metal catalyst in an amount of 0.1 to 1,000 ppm in terms of the mass of the platinum-group metal; and
   (D1) a thermally conductive filler in an amount of 300 to 4,000 parts by mass.
<4> The thermally conductive silicone composite sheet according to <3>, wherein the addition-curable silicone rubber composition contains (E1) a dimethylpolysiloxane having one end of the molecular chain blocked by a trialkoxy group, wherein the dimethylpolysiloxane serves as a surface-treatment agent and is represented by formula (2): 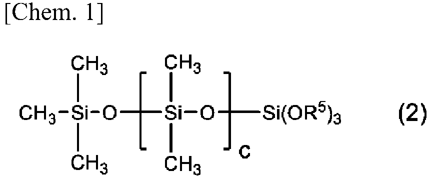 wherein R⁵s are each independently an alkyl group having 1 to 6 carbon atoms, and c is a number from 4 to 100.
<5> The thermally conductive silicone composite sheet according to any one of <1> to <4>, wherein the thermally conductive composition constituting the layer (X) is the same as the thermally conductive silicone rubber composition constituting the high-hardness thermally conductive silicone rubber layer (Y).
<6> The thermally conductive silicone composite sheet according to any one of <1> to <5>, wherein the low-hardness thermally conductive silicone rubber layer (Z) is a cured product of an addition-curable silicone rubber composition comprising the components (A2) to (E2) defined as:
   (A2) an organopolysiloxane containing two or more alkenyl groups per molecule and having an average polymerization degree of 100 to 2,000 in an amount of 100 parts by mass;
   (B2) an organohydrogen polysiloxane containing two or more hydrosilyl groups per molecule in an amount such that a ratio of the number of moles of hydrosilyl groups in the component (B2) to the number of moles of alkenyl groups in the component (A2) is 0.5 to 1.5;
   (C2) a platinum-group metal catalyst in an amount of 0.1 to 1,000 ppm in terms of the mass of the platinum-group metal;
   (D2) a thermally conductive filler in an amount of 500 to 4,000 parts by mass; and
   (E2) a dimethylpolysiloxane having one end of the molecular chain blocked by a trialkoxy group in an amount of 10 to 300 parts by mass, wherein the dimethylpolysiloxane serves as a surface-treatment agent and is represented by formula (2): 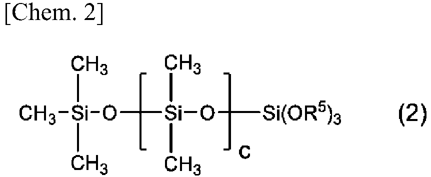 wherein R⁵s are each independently an alkyl group having 1 to 6 carbon atoms, and c is a number from 4 to 100.
<7> The thermally conductive silicone composite sheet according to any one of <1> to <6>, wherein the high-hardness thermally conductive silicone rubber layer (Y) has a thickness of 0.15 to 0.5 mm, and the thermally conductive silicone composite sheet has an overall thickness of 0.3 to 10 mm.
<8> The thermally conductive silicone composite sheet according to any one of <1> to <6>, wherein the support layer (X) has a thickness of 0.03 to 0.10 mm.

### Advantageous Effects of Invention

The thermally conductive silicone composite sheet of the present invention can be manufactured in a simple and stable manner by laminating a high-hardness thermally conductive silicone rubber layer and a low-hardness thermally conductive silicone rubber layer of the thermally conductive silicone composite sheet in a good adhesion state. Since the high-hardness thermally conductive silicone rubber layer is applied onto a support layer filled with a thermally conductive composition, a release-treated resin film as a base material is unnecessary, and the user can omit the process of peeling off such a base material.

Furthermore, because the high-hardness thermally conductive silicone rubber layer is cured by addition curing, its tackiness is reduced, allowing the layer to be stored prior to lamination with the low-hardness thermally conductive silicone rubber layer without covering the coated surface with a release-treated resin film.

In addition, when oil bleeding occurs from the low-hardness thermally conductive silicone rubber layer after adhesion with the low-hardness thermally conductive silicone layer, the support layer having a network structure is able to retain the bled oil, resulting in oil-bleed resistance that is superior to that of conventional thermally conductive silicone composite sheets.

Accordingly, the thermally conductive silicone composition of the present invention is useful as a heat dissipation material for an electric vehicle, a mobile device, and a wearable device, which require a reduction in weight.

### Description of Embodiments

The present invention will now be described in more detail.

### <Thermally conductive silicone composite sheet>

The present invention is directed to a thermally conductive silicone composite sheet including a high-hardness thermally conductive silicone rubber layer (Y) laminated to a support layer (X) of a mesh reinforcement filled with a cured product of a thermally conductive composition and a low-hardness thermally conductive silicone rubber layer (Z) laminated to the high-hardness thermally conductive silicone rubber layer (Y), wherein the hardness of the high-hardness silicone rubber layer (Y) is higher than that of the low-hardness silicone rubber layer (Z).

The thermally conductive silicone composite sheet includes a support layer (X), a high-hardness thermally conductive silicone rubber layer (Y), and a low-hardness thermally conductive silicone rubber layer (Z). The support layer (X) is composed of a mesh reinforcement filled with a cured product of a thermally conductive composition, and the high-hardness thermally conductive silicone rubber layer (Y) and the low-hardness thermally conductive silicone rubber layer (Z) are each a cured product of an addition-curable silicone rubber composition. The silicone rubber layer (Y) and the silicone rubber layer (Z) can be adhered to each other without applying a primer layer therebetween by using addition-curable silicone rubber compositions for these two layers. A primer treatment may be performed as needed.

These will be described in more detail below.

### <Support layer (X)>

The support layer (X) is a mesh reinforcement filled with a cured product of a thermally conductive material composition (thermally conductive material), imparts good workability due to tack-free to the thermally conductive silicone composite sheet of the present invention, and serves to work as an oil-bleeding suppression mechanism.

### <Mesh reinforcement>

Examples of the mesh reinforcement to be used include inorganic fiber cloth such as glass cloth, ceramic cloth, and quartz cloth and organic fiber cloth such as nylon and polyester, among which inorganic fiber cloth is preferable, and glass cloth is more preferable, considering heat resistance and so on.

The cloth opening and weaving method are also not particularly limited, but it is preferable to use yarn with a count of 5 Tex or more and a density of 25 threads or more per 25 mm. A sufficient reinforcing effect can be obtained by using such a mesh reinforcement.

The thickness of the mesh reinforcement is preferably 0.02 to 0.0.09 mm and more preferably 0.04 to 0.08 mm. If the thickness of the mesh reinforcement is less than 0.02 mm, the strength of the laminate sheet may be significantly decreased. In contrast, if the thickness is greater than 0.09 mm, the desired thermal conductivity may be difficult to be obtained.

### <Material for filling>

The material for filling is not particularly limited as long as it is a thermally conductive material, but is preferably a thermally conductive silicone rubber material (thermally conductive silicone rubber composition). Further considering the cost effectiveness and adhesion properties, the material is more preferably the same as the material that is used in the high-hardness thermally conductive silicone rubber layer (Y) described later.

When the surface roughness Rz of the support layer (X) as measured by a surface texture measuring device SV-C3200 (manufactured by Daiichi Kagaku Inc.) is preferably 20 µm or more, more preferably 25 µm or more, and further preferably 30 µm or more, the effects of improving the workability and suppressing the oil bleeding due to the above-described tack-free are favorable.

### <High-hardness thermally conductive silicone rubber layer (Y)>

The high-hardness thermally conductive silicone rubber layer (Y) carries the low-hardness layer in the thermally conductive silicone composite sheet of the present invention and serves as a reinforcement layer thereof. This silicone rubber layer (Y) is preferably composed of the cured product of an addition-curable thermally conductive silicone composition containing the following components (A1) to (D1). Each component will be described below.

### [(A1) Organopolysiloxane]

The organopolysiloxane of the component (A1) is an organopolysiloxane that includes two or more alkenyl groups bonding to silicon atoms per molecule and has an average polymerization degree of 100 to 20,000. The organopolysiloxane may preferably be a linear organopolysiloxane including repeating diorganosiloxane units in the main chain portion, but may have a branched structure in a part of the molecular structure or may be in a cyclic form. In terms of physical properties such as the mechanical strength of the cured product, a linear diorganopolysiloxane is preferable.

Examples of the functional group other than the alkenyl group, bonding to a silicon atom, include monovalent hydrocarbon groups preferably having 1 to 10 carbon atoms, particularly preferably 1 to 6 carbon atoms. Examples of the monovalent hydrocarbon group include alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, an nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenyl group; and aralkyl groups such as a benzyl group, a phenylethyl group, a phenylpropyl group, and a methylbenzyl group. Among these groups, preferred are alkyl groups having 1 to 3 carbon atoms, such as a methyl group, an ethyl group, and a propyl group, and a phenyl group. Those obtained by substituting a part of hydrogen atoms bonding to carbon atoms in these groups with halogen atoms may be used. It is not essential that all functional groups other than the alkenyl group bonded to a silicon atom be the same.

Examples of the alkenyl group include alkenyl groups having 2 to 8 carbon atoms, such as a vinyl group, an allyl group, a propenyl group, an ispropenyl group, a butenyl group, a hexenyl group, and a cyclohexenyl group. In particular, a vinyl group and an allyl group are preferable, and a vinyl group is particularly preferable. The component (A1) may include two or more alkenyl groups, bonding to silicon atoms, per molecule and may include preferably 2 to 20 alkenyl groups and more preferably 2 to 10 alkenyl groups.

The organopolysiloxanes of the component (A1) may be used alone or in combination of two or more.

The organopolysiloxane of the component (A1) is preferably linear and may include a suitable degree of branching within a range that does not impair the rubber strength as a thermally conductive high-hardness layer and may be a mixture of two or more organopolysiloxanes having different molecular structures or polymerization degrees.

Furthermore, the organopolysiloxane preferably has an average polymerization degree of 100 to 20,000 and particularly preferably 1,000 to 10,000. The average polymerization degree is a value determined as a number average polymerization degree in terms of polystyrene by gel permeation chromatography (GPC).

### [Measurement condition]

Eluent: tetrahydrofuran (THF);
Flow rate: 0.6 mL/min;
Detector: differential refractometer (RI); and
Column: TSK Guardcolumn SuperH-L
   TSKgel SuperH4000 (6.0 mm I.D. × 15 cm × 1)
   TSKgel SuperH3000 (6.0 mm I.D. × 15 cm × 1)
   TSKgel SuperH2000 (6.0 mm I.D. × 15 cm × 2)
   (all are manufactured by Tosoh Corporation);
Column temperature: 40°C; and
Sample injection volume: 20 µL (THF solution with a concentration of 0.5% by mass).

In the addition-curable thermally conductive silicone composition including the components (A1) to (D1) described above, the proportion of the component (A1) in the whole composition is preferably from 5% by mass to 50% by mass, more preferably from 7% by mass to 45% by mass, and further preferably from 10% by mass to 40% by mass.

### [(B1) Organohydrogen polysiloxane]

The component (B1) is an organohydrogen polysiloxane including two or more, preferably 2 to 100, hydrogen atoms (hydrosilyl groups) directly bonding to silicon atoms per molecule and functions as a crosslinking agent for the component (A1). That is, the hydrosilyl groups in the component (B1) and the alkenyl groups in the component (A) are reacted by hydrosilylation in the presence of a platinum catalyst (C1) described later to give a three-dimensional network structure having a crosslinking structure. If the number of hydrosilyl groups is one or less, there is a risk of not curing.

The organohydrogen polysiloxane is represented by, for example, the following formula (1):

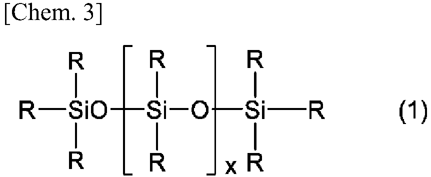

In the formula (1), Rs are each independently a hydrogen atom or a monovalent hydrocarbon group not having an aliphatic unsaturated bond, provided that two or more of Rs are hydrogen atoms and x is a number from 1 or more, preferably a number from 2 to 100, and more preferably a number from 3 to 50. In the formula (1), the hydrogen atom directly bonding to a silicon atom may be located either on a side chain or at an end, and two or more of Rs on a side chain are preferably hydrogen atoms.

In the formula (1), the monovalent hydrocarbon group not having an aliphatic unsaturated bond represented by R is a monovalent hydrocarbon group having preferably 1 to 10 carbon atoms and particularly preferably 1 to 6 carbon atoms. Examples of the monovalent hydrocarbon group not having an aliphatic unsaturated bond include alkyl groups such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; cycloalkyl groups such as a cyclopentyl group, a cyclohexyl group, and a cycloheptyl group; aryl groups such as a phenyl group, a tolyl group, a xylyl group, a naphthyl group, and a biphenyl group; and aralkyl groups such as benzyl group, a phenylethyl group, a phenylpropyl group, and a methylbenzyl group. In particular, preferred are alkyl groups having 1 to 3 carbon atoms, such as a methyl group, an ethyl group, and a propyl group, and a phenyl group. Those obtained by substituting a part of hydrogen atoms bonding to carbon atoms in these groups with halogen atoms may be used. It is not essential that Rs be the same.

The amount of the component (B1) is an amount such that the ratio of the number of hydrosilyl groups in the component (B1) to the number of alkenyl groups in the component (A1) is 1.0 or more, preferably 1.1 or more, and further preferably 1.2 or more. The upper limit is not particularly limited, but it is 3.5 or less and preferably is 2.5 or less.

When the amount of the component (B1) is within this range, it is possible to obtain good adhesion with a low-hardness thermally conductive silicone rubber layer (Z) described later.

The organohydrogen polysiloxane of the component (B1) may be used alone or in combination of two or more.

### [(C1) Platinum-group metal catalyst]

The component (C1) is an addition reaction catalyst that accelerates the addition reaction between the alkenyl group of the component (A1) and the hydrosilyl group of the component (B1). As the catalyst, a well-known platinum-group metal catalyst that is used in hydrosilylation reaction may be used, and examples thereof include platinum-group metals such as platinum (including platinum black), rhodium, and palladium; platinum chloride such as H₂PtCl₄·nH₂O, H₂PtCl₆·nH₂O, NaHPtCl₆·nH₂O, KaHPtCl₆·nH₂O, Na₂PtCl₆·nH₂O, K₂PtCl₄·nH₂O, PtCl₄·nH₂O, PtCl₂, and Na₂HPtCl₄·nH₂O (provided that n, in the formula, is a number from 0 to 6, preferably 0 or 6); chloroplatinic acid, a chloroplatinic acid salt, alcoholmodified chloroplatinic acid (see U.S. Patent No. 3,220,972), a complex of chloroplatinic acid and olefin (see U.S. Patent Nos. 3,159,601, 3,159,662, and 3,775,452), platinum-group metals, such as platinum black and palladium, supported on a carrier such as alumina, silica, and carbon; a rhodium-olefin complex, and complexes of chlorotris(triphenylphosphine)rhodium (Wilkinson's catalyst), platinum chloride, chloroplatinic acid, or a chloroplatinic acid salt with vinyl group-containing siloxane, particularly, vinyl group-containing cyclic siloxane. The platinum-group metal catalyst may be used alone or in combination of two or more.

The amount of the component (C1) may be the so-called catalyst quantity (that is, the effective amount that accelerates the addition reaction). The amount is 0.1 to 1,000 ppm, preferably 1 to 500 ppm, in terms of the mass of the platinum-group metal element relative to the component (A1).

### [(D1) Thermally conductive filler]

The thermally conductive filler (D1) may be a known filler that is included in thermally conductive compositions, but is preferably at least one selected from the group consisting of metals, metal oxides, and metal nitrides. That is, the thermally conductive filler (D1) may be a known thermally conductive filler, which may be, for example, a metal such as non-magnetic copper or aluminum; a metal oxide such as alumina, silica, magnesia, red oxide, beryllia, titania, or zirconia; a metal nitride such as aluminum nitride, silicon nitride, or boron nitride; artificial diamond; or silicon carbide. The thermally conductive filler may have an average particle diameter of 0.1 to 70 µm, preferably 0.5 to 60 µm, and further preferably 1 to 50 µm. The thermally conductive filler may be used alone or in combination of two or more. Alternatively, two or more types of particles having different average particle diameters may be used. In the present invention, the average particle diameter refers to a volume average particle diameter and is a value measured by a Microtrac particle size distribution measuring apparatus MT3300EX (manufactured by Nikkiso Co., Ltd.).

The blending amount of the thermally conductive filler is 300 to 4,000 parts by mass, preferably 500 to 3,500 parts by mass, based on 100 parts by mass of the component (A1). If the blending amount of the thermally conductive filler is greater than 4,000 parts by mass based on 100 parts by mass of the component (A1), the adhesion with a low-hardness thermally conductive silicone rubber layer (Z) described later may be decreased. If the blending amount of the thermally conductive filler is less than 300 parts by mass based on 100 parts by mass of the component (A1), the desired thermal conductivity may not be obtained.

The high-hardness thermally conductive silicone rubber composition of the present invention may contain a surface-treatment agent such as a silane coupling agent for improving the affinity between the component (D1) and the component (A1).

### [(E1) Surface-treatment agent]

In the high-hardness thermally conductive silicone rubber layer (Y), it is preferable to add, as a surface-treatment agent for improving the affinity between the component (D1) and the component (A1), a dimethylpolysiloxane (E1) having one end of the molecular chain blocked by a trialkoxy group represented by the following formula (2) to the addition-curable thermally conductive silicone composition. 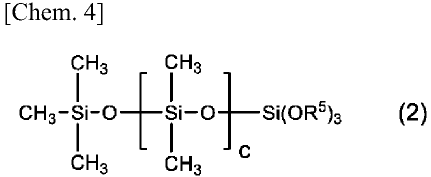 (In the formula, R⁵s are each independently an alkyl group having 1 to 6 carbon atoms, and c is a number from 4 to 100).

The amount of the component (E1) when blended in the addition-curable thermally conductive silicone composition is preferably 10 to 300 parts by mass, more preferably 20 to 150 parts by mass, based on 100 parts by mass of the component (A1). When the proportion of this component is greater than 300 parts by mass based on 100 parts by mass of the component (A1), oil separation is easily caused, and the adhesion between the layer (Y) and the layer (Z) may be decreased. When the proportion of this component is less than 10 parts by mass based on 100 parts by mass of the component (A1), the wettability of the organopolysiloxane (A1) and the thermally conductive filler (D1) is decreased, and the moldability of the composition may be decreased.

The surface-treatment agent of the component (E1) may be used alone or in combination of two or more.

Furthermore, as needed, the addition-curable thermally conductive silicone composition may contain a pigment, an inner releasing agent, and/or a plasticizer as optional agent(s).

### <Low-hardness thermally conductive silicone rubber layer (Z)>

The low-hardness thermally conductive silicone rubber layer (Z) provides stressrelaxation, absorbs tolerance, and decreases thermal contact resistance in the thermally conductive silicone composite sheet of the present invention. This silicone rubber layer (Z) is composed of a cured product of the addition-curable thermally conductive silicone composition including the following components (A2) to (D2).

### [(A2) Organopolysiloxane]

The organopolysiloxane of the component (A2) is an organopolysiloxane having two or more alkenyl groups bonding to silicon atoms per molecule and having an average polymerization degree of 100 to 2,000. The organopolysiloxane is preferably linear, but may include a suitable degree of branching within a range that does not impair the rubber strength as a thermally conductive low-hardness layer and may be a mixture of two or more types of organopolysiloxanes having different molecular structures or polymerization degrees. In terms of physical properties such as the mechanical strength of the cured product, a linear diorganopolysiloxane is preferable.

Examples of the functional group other than the alkenyl group, bonding to a silicon atom, include the same functional groups as those mentioned in the component (A1).

The component (A2) in the low-hardness thermally conductive silicone rubber layer (Z) may include two or more alkenyl groups bonding to silicon atoms per molecule, and may include preferably 2 to 20, more preferably 2 to 10, alkenyl groups.

The organopolysiloxane of the component (A2) may be used alone or in combination of two or more.

The component (A2) in the low-hardness thermally conductive silicone rubber layer (Z) has an average polymerization degree of 100 to 2,000, particularly preferably 200 to 1,000. The average polymerization degree refers to a value determined as a number average polymerization degree in terms of polystyrene by gel permeation chromatography (GPC).

### [Measurement condition]

Eluent: tetrahydrofuran (THF);
Flow rate: 0.6 mL/min;
Detector: differential refractometer (RI);
Column: TSK Guardcolumn SuperH-L
   TSKgel SuperH4000 (6.0 mm I.D. × 15 cm × 1)
   TSKgel SuperH3000 (6.0 mm I.D. × 15 cm × 1)
   TSKgel SuperH2000 (6.0 mm I.D. × 15 cm × 2)
   (all are manufactured by Tosoh Corporation);
Column temperature: 40°C; and
Sample injection volume: 20 µL (THF solution with a concentration of 0.5% by mass)

In the addition-curable thermally conductive silicone composition including the above components (A2) to (D2), the proportion of the component (A2) to the whole composition is preferably from 5% by mass to 45% by mass, more preferably from 7% by mass to 40% by mass, and further preferably from 10% by mass to 40% by mass.

### [(B2) Organohydrogen polysiloxane]

The component (B2) is an organohydrogen polysiloxane including two or more, preferably 2 to 100, hydrogen atoms (hydrosilyl groups), directly bonding to silicon atoms, per molecule, and functions as a crosslinking agent for the component (A2), and examples thereof include the same as those mentioned in the component (B1).

The amount of the component (B2) is such that the ratio of the number of hydrosilyl groups in the component (B2) to the number of alkenyl groups in the component (A2) is 1.5 or less, preferably 1.3 or less, and further preferably 1.1 or less. The lower limit is not particularly limited, but it is 0.5 or more and preferably 0.6 or more.

When the amount of the component (B2) is within this range, it is easy to lower the hardness of the layer (Z), and the adhesion with the layer (Y) is also possible.

The organohydrogen polysiloxane of the component (B2) may be used alone or in combination of two or more.

### [(C2) Platinum-group metal catalyst]

The component (C2) is an addition reaction catalyst for accelerating the addition reaction between the alkenyl group of the component (A2) and the hydrosilyl group of the component (B2). As the catalyst, a well-known platinum-group metal catalyst used in hydrosilylation reaction may be used, and examples thereof include the same as those mentioned in the component (C1). The platinum-group metal catalyst may be used alone or in combination of two or more.

The amount of the component (C2) may be the so-called catalyst quantity (that is, the effective amount that accelerates the addition reaction). The amount is 0.1 to 1,000 ppm, preferably 1 to 500 ppm, in terms of the mass of the platinum-group metal element relative to the component (A2).

### [(D2) Thermally conductive filler]

The thermally conductive filler (D2) may be a known filler that is included in thermally conductive compositions, but is preferably at least one selected from the group consisting of metals, metal oxides, and metal nitrides, and examples thereof include the same as those mentioned in the component (D1).

The blending amount of the component (D2) is 500 to 4,000 parts by mass, preferably 700 to 3,000 parts by mass, based on 100 parts by mass of the component (A2). When the blending amount of the thermally conductive filler is greater than 4,000 parts by mass based on 100 parts by mass of the component (A2), not only is a silicone rubber layer with a desired hardness not obtained, but adhesion to the high-hardness thermally conductive silicone rubber layer (Y) may also deteriorate. When the blending amount is less than 500 parts by mass based on 100 parts by mass of the component (A2), the desired thermal conductivity may not be achieved.

### [(E2) Surface-treatment agent]

As the surface-treatment agent for improving the affinity between the component (D2) and the component (A2), a dimethylpolysiloxane (E2) having one end of the molecular chain blocked by a trialkoxy group and being represented by the following formula (2) is added to the addition-curable thermally conductive silicone composition. This surface-treatment agent also contributes to lowering the hardness of the low-hardness thermally conductive silicone rubber layer (Z). 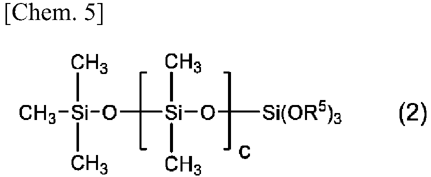 (In the formula, R⁵s are each independently an alkyl group having 1 to 6 carbon atoms, and c is a number from 4 to 100).

The amount of the component (E2) to be blended with the addition-curable thermally conductive silicone composition is 10 to 300 parts by mass, preferably 20 to 150 parts by mass, based on 100 parts by mass of the component (A2). When the proportion of this component exceeds 300 parts by mass based on 100 parts by mass of the component (A2), oil separation is easily caused, and adhesion between the layer (Y) and the layer (Z) may be decreased. When the proportion of this component is less than 10 parts by mass based on 100 parts by mass of the component (A2), the wettability of the organopolysiloxane (A2) and the thermally conductive filler (D2) is decreased, the moldability of the composition is decreased, and it may be difficult to achieve low hardness.

The surface-treatment agent of the component (E2) may be used alone or in combination of two or more.

Furthermore, as needed, the addition-curable thermally conductive silicone composition may further contain a pigment, an inner releasing agent, and a plasticizer as optional agents.

### <Manufacturing method>

### <Process 1>

The process (1) is a process of applying a thermally conductive material to a mesh reinforcement to mold a filled support layer (X).

The filling material may be applied to the mesh reinforcement and cured to eliminate the need for a resin film for producing the sheet when a high-hardness thermally conductive silicone rubber layer (Y) is laminated in the subsequent process.

The filling method may be a known method. A filler solution is prepared by diluting a thermally conductive material with a solvent and is applied to a mesh reinforcement. Successively, the filler solution is continuously applied to the mesh reinforcement using a coating apparatus, such as a knife coater and a kiss coater, equipped with a drying furnace, a heating furnace, and a winding device, and then the solvent or the like is dried out, and heating at preferably 80°C to 120°C, more preferably about 100°C to 150°C, are performed for curing to obtain a filled mesh reinforcement.

### <Process 2>

The process (2) is a process of laminating a high-hardness thermally conductive silicone composition on the support layer (X) produced in the process (1) and performing curing treatment to obtain a high-hardness thermally conductive silicone rubber layer (Y).

The method of coating the support layer (X) with a high-hardness thermally conductive silicone composition is not particularly limited. For example, a komma coater may be used to continuously laminate the high-hardness thermally conductive silicone rubber layer (Y) on the support layer (X) by one process. In addition, as needed, the high-hardness thermally conductive silicone composition may be diluted with a solvent (such as xylene and toluene), and the solvent may be volatilized after coating.

In the present invention, it is preferable to complete the curing reaction of the high-hardness thermally conductive silicone rubber layer (Y) before the lamination of a low-hardness thermally conductive silicone rubber layer (Z) described later. The curing allows the layer (Y) to have reduced tack force on the surface, which therefore eliminates the need to protect it using a release-treated resin film or the like.

The curing conditions are at 100°C to 170°C for 5 to 30 minutes, preferably at 120°C to 150°C for 10 to 20 minutes.

The tack force of the cured layer (Y) surface is preferably 30 gf or less, more preferably 20 gf or less, and further preferably 10 gf or less. When the tack force is within this range, even if the sheet-shaped molded high-hardness thermally conductive silicone rubber layer is directly wound in a roll form, sticking (blocking) of the sheet can be suppressed.

The hardness of the obtained sheet can be measured by a Shore A hardness tester by the method described in JIS K6253-1: 2012.

### <Process 3>

The process (3) is a process of laminating a low-hardness thermally conductive silicone composition on the high-hardness thermally conductive silicone rubber layer (Y) and curing it to adhere the low-hardness thermally conductive silicone rubber layer (Z) to the (Y) to obtain a thermally conductive silicone composite sheet.

The hardness of the obtained sheet can be measured using an Asker C hardness tester by the method described in JIS K7312: 1996.

The method for forming the layer (Z) by laminating the low-hardness thermally conductive silicone composition on the layer (Y) and curing it is not particularly limited, and examples thereof include coating and press molding.

The curing conditions are at 100°C to 150°C for 5 to 30 minutes, preferably at 110°C to 130°C for 10 to 20 minutes.

The Asker C hardness of the cured low-hardness thermally conductive silicone layer is preferably 2 to 30 and further preferably 20 or less. When the hardness of the low-hardness thermally conductive silicone layer falls within this range, its favorable compression characteristics help reduce the stress applied to the heat-generating member.

### <Thermally conductive silicone composite sheet>

In the present invention, the high-hardness thermally conductive silicone rubber layer (Y) can have a thickness of 0.15 mm or more and 0.5 mm or less, the cured low-hardness thermally conductive silicone rubber layer (Z) can have an Asker C hardness of 30 or less, and the thermally conductive silicone composite sheet can have a thickness of 0.3 mm or more and 10 mm or less.

In the present invention, the high-hardness thermally conductive silicone rubber layer (Y) in the thermally conductive silicone composite sheet can have a Shore A hardness of 50 or more and 97 or less and a thickness of 0.15 mm or more and 0.5 mm or less.

The thermally conductive silicone composite sheet of the present invention does not require a resin film, which is required for manufacturing ordinary sheet-shaped silicone, during its manufacturing, and blocking can be also suppressed when the high-hardness thermally conductive silicone rubber layer (Y) is stored. Furthermore, the low-hardness thermally conductive silicone rubber layer (Z) can be laminated in a good adhesion state, and the obtained thermally conductive silicone composite sheet exhibits excellent workability and compression properties.

### Examples

The present invention will now be specifically described using Working examples and Comparative examples, but the present invention is not limited to the following Working examples.

### <Preparation of compositions 1-A to 1-D and compositions 2-A to 2-C>

Compositions 1-A to 1-D and compositions 2-A to 2-C were prepared by mixing respective components in the formulations shown in Tables 1 and 2.

Compositions 1-A, 1-B, 1-C, and 1-D were kneaded using a kneader.

Compositions 2-A, 2-B, and 2-C were kneaded using a planetary mixer.

### [Component (a)]

Component (a-1): dimethylpolysiloxane, capped at both ends with a dimethyl vinyl group, having an average polymerization degree of 8,000 and being represented by the following formula (3); and

Component (a-2): dimethylpolysiloxane, capped at both ends with a dimethyl vinyl group, having an average polymerization degree of 400 and being represented by the following formula (3): 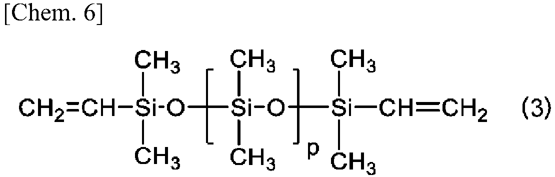 (p is a number satisfying the above-mentioned average polymerization degree.)

### [Component (b)]

Component (b-1): organohydrogen polysiloxane represented by the following formula (4), wherein q = 20 and r = 9

Component (b-2): organohydrogen polysiloxane represented by the following formula (4), wherein q = 27, and r = 3

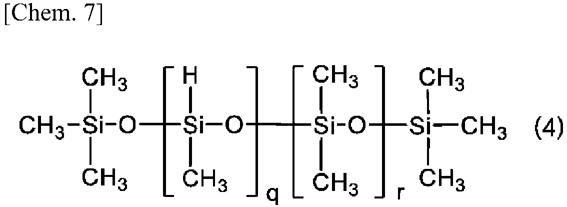

### [Component (c)]

5% chloroplatinic acid 2-ethylhexanol solution

### [Component (d)]

Component (d-1): aluminum hydroxide having an average particle diameter of 2 µm
Component (d-2): aluminum hydroxide having an average particle diameter of 8 µm
Component (d-3): aluminum hydroxide having an average particle diameter of 50 µm
Component (d-4): aluminum oxide having an average particle diameter of 1 µm
Component (d-5): aluminum oxide having an average particle diameter of 10 µm
Component (d-6): aluminum oxide having an average particle diameter of 45 µm
Component (d-7): aluminum oxide having an average particle diameter of 70 µm

### [Component (e)]

Dimethylpolysiloxane, capped at one end with a trimethoxysilyl group, represented by the following formula (5):

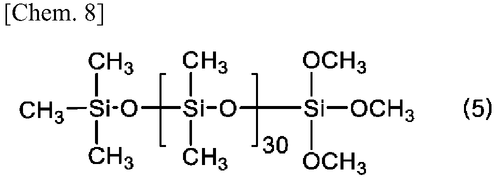

### [Component (f)]

Addition reaction inhibitor: 2-ethynyl-2-undecanol

### [Component (g)]

Inner releasing agent: dimethyl diphenyl silicone oil (manufactured by Shin-Etsu Chemical Co., Ltd., "KF-54")

### [Component (h)]

Plasticizer: dimethyl silicone oil (manufactured by Shin-Etsu Chemical Co., Ltd., "KF-96-100cs")

### <Evaluation of high-hardness thermally conductive silicone rubber layer (Y)>

### [Manufacturing method]

The obtained compositions 1-A to 1-D were each molded into a sheet-like shape with a thickness of 6 mm and cured to obtain a sheet-shaped cured product (hereinafter, referred to as sheet).

### [Thermal conductivity]

Using two of the obtained sheets, the thermal conductivity (W/m·K) of each sheet was measured using a thermal conductivity meter (TPA-501, manufactured by Kyoto Electronics Manufacturing Co., Ltd.).

### [Tack force]

The tack force of the obtained sheet was measured with a solder paste-type tackiness tester.

### [Hardness]

The hardness of the obtained sheet was measured using a Shore A hardness tester by the method described in JIS K6253-1: 2012.

**[Table 1]**

| Component (part by mass) | | Composition | | | |
|---|---|---|---|---|---|
| | | 1-A | 1-B | 1-C | 1-D |
| a | a-1 | 100 | 100 | 100 | 100 |
| | a-2 | 40 | 40 | 50 | 50 |
| b | b-1 | 0.08 | 0.11 | | |
| | b-2 | | | 0.08 | 0.11 |
| c | | 1.5 | 1.5 | 1.5 | 1.5 |
| d | d-1 | 250 | 250 | | |
| | d-2 | 550 | 550 | | |
| | d-3 | | | | |
| | d-4 | | | 760 | 760 |
| | d-5 | | | 2330 | 2330 |
| | d-6 | | | | |
| | d-7 | | | | |
| e | | 20 | 20 | 50 | 50 |
| f | | 0.5 | 0.5 | 0.5 | 0.5 |
| g | | 2 | 2 | 0 | 0 |
| h | | 2 | 2 | 0 | 0 |
| Molar ratio (b)/(a) | | 1.5 | 2 | 1.2 | 1.7 |
| Total amount of component (d) | | 800 | 800 | 3090 | 3090 |
| Thermal conductivity (W/m·K) | | 1.8 | 2.2 | 4.2 | 4.4 |
| Tack force (gf) | | 5 | 8 | 7 | 10 |
| Hardness after curing (Shore A) | | 87 | 92 | 61 | 63 |

### <Evaluation of low-hardness thermally conductive silicone rubber layer (Z)>

### [Manufacturing method]

The obtained compositions 2-A to 2-C were each molded into a sheet-like shape with a thickness of 6 mm and cured to obtain a sheet-shaped cured product (hereinafter, referred to as sheet).

### [Thermal conductivity]

Using two of the obtained sheets, the thermal conductivity (W/m·K) of each sheet was measured using a thermal conductivity meter (TPA-501, manufactured by Kyoto Electronics Manufacturing Co., Ltd.).

### [Hardness]

The hardness of the obtained sheet was measured using an Asker C hardness tester by the method described in JIS K7312: 1996.

**[Table 2]**

| Component (part by mass) | | Composition | | |
|---|---|---|---|---|
| | | 2-A | 2-B | 2-C |
| a | a-1 | | | |
| | a-2 | 100 | 100 | 100 |
| b | b-1 | | | |
| | b-2 | 0.28 | 0.33 | 0.37 |
| c | | 1 | 1 | 1 |
| d | d-1 | 150 | | |
| | d-2 | 300 | | |
| | d-3 | 300 | | |
| | d-4 | | 275 | 413 |
| | d-5 | | 210 | 315 |
| | d-6 | | 150 | 225 |
| | d-7 | | 160 | 240 |
| e | | 15 | 32 | 45 |
| f | | 0.3 | 0.3 | 0.3 |
| g | | 12 | 5 | 4 |
| h | | 10 | 5 | 4 |
| Thermal conductivity (W/m·K) | | 1.9 | 4.4 | 5.3 |
| Hardness after curing (Asker C) | | 5 | 10 | 17 |

### <Production of composite sheet>

### [Mesh reinforcement]

As the mesh reinforcement for producing a support layer (X), glass cloth (thickness: 30 µm) made of 5 Tex glass fibers and having 50 threads per 25 mm in both warp and weft directions was used.

### (Working example 1)

A glass cloth filler solution was obtained by adding 80% by mass of xylene to the composition 1-A. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 120°C for 10 minutes to obtain a support layer (X) having a thickness of 0.05 mm.

Then, 20% by mass of xylene was added to the composition 1-A to prepare a coating liquid. The coating liquid was coated on one surface of the support layer (X) with a Komma coater at a coating speed of 0.5 m/min. The oven temperature was set to 80°C/80°C/150°C/150°C, and heating was performed for 15 minutes in total to obtain a laminate including the cured product of the composition 1-A as a silicone rubber layer (Y) on the support layer (X).

Subsequently, the composition 2-A was coated on the surface of the silicone rubber layer (Y). Press molding was performed at 120°C for 10 minutes to cure the composition 2-A to obtain a thermally conductive silicone composite sheet composed of the support layer (X), the silicone rubber layer (Y), and the cured product of the composition 2-A as a silicone rubber layer (Z) laminated in this order.

X: 0.05 mm, Y: 0.15 mm, Z: 0.8 mm, total thickness: 1.0 mm.

### (Working example 2)

A glass cloth filler solution was obtained by adding 60% by mass of xylene to the composition 1-B. The filler solution was put in a container having a capacity large enough to accommodate glass cloth. Subsequently, the glass cloth was placed in the container and was immersed in the filler solution to be impregnated with the filler solution. Once the glass cloth was sufficiently impregnated with the filler solution, the cloth and was then continuously pulled up to remove excess filler solution from the glass cloth. The glass cloth was then put in an oven, dried at 80°C for 10 minutes, and cured at 120°C for 10 minutes to obtain a support layer (X) having a thickness of 0.05 mm.

Then, 20% by mass of xylene was added to the composition 1-B to prepare a coating liquid. The coating liquid was coated on one surface of the support layer (X) with a Komma coater at a coating speed of 0.5 m/min. The oven temperature was set to 80°C/80°C/150°C/150°C, and a laminate including the cured product of the composition 1-B as a silicone rubber layer (Y) on the support layer (X) was obtained.

Subsequently, the composition 2-B was coated on the surface of the silicone rubber layer (Y). Press molding was performed at 120°C for 10 minutes to cure the composition 2-B to obtain a thermally conductive silicone composite sheet composed of the support layer (X), the silicone rubber layer (Y), and the cured product of the composition 2-B as a silicone rubber layer (Z) laminated in this order.

X: 0.05 mm, Y: 0.10 mm, Z: 0.35 mm, total thickness: 0.5 mm.

### (Working example 3)

A glass cloth filler solution was obtained by adding 80% by mass of xylene to the composition 1-A. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 120°C for 10 minutes to obtain a support layer (X) having a thickness of 0.05 mm.

Then, 20% by mass of xylene was added to the composition 1-A to prepare a coating liquid. The coating liquid was coated on one surface of the support layer (X) with a Komma coater at a coating speed of 0.5 m/min. The oven temperature was set to 80°C/80°C/150°C/150°C, and heating was performed for 15 minutes in total to obtain a laminate including the cured product of the composition 1-A as a silicone rubber layer (Y) on the support layer (X).

Subsequently, the composition 2-A was coated on the surface of the silicone rubber layer (Y). Press molding was performed at 120°C for 10 minutes to cure the composition 2-A to obtain a thermally conductive silicone composite sheet composed of the support layer (X), the silicone rubber layer (Y), and the cured product of the composition 2-A as a silicone rubber layer (Z) laminated in this order.
X: 0.05 mm, Y: 0.15 mm, Z: 1.8 mm, total thickness: 2.0 mm

### (Working example 4)

A glass cloth filler solution was obtained by adding 60% by mass of xylene to the composition 1-C. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 120°C for 10 minutes to obtain a support layer (X) having a thickness of 0.05 mm.

Then, 30% by mass of xylene was added to the composition 1-C to prepare a coating liquid. The coating liquid was coated on one surface of the support layer (X) with a Komma coater at a coating speed of 0.5 m/min. The oven temperature was set to 80°C/80°C/150°C/150°C, and heating was performed for 15 minutes in total to obtain a laminate including the cured product of the composition 1-C as a silicone rubber layer (Y) on the support layer (X).

Subsequently, the composition 2-A was coated on the surface of the silicone rubber layer (Y). Press molding was performed at 120°C for 10 minutes to cure the composition 2-A to obtain a thermally conductive silicone composite sheet composed of the support layer (X), the silicone rubber layer (Y), and the cured product of the composition 2-A as a silicone rubber layer (Z) laminated in this order.
X: 0.05 mm, Y: 0.15 mm, Z: 0.8 mm, total thickness: 1.0 mm

### (Working example 5)

A glass cloth filler solution was obtained by adding 60% by mass of xylene to the composition 1-C. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 120°C for 10 minutes to obtain a support layer (X) having a thickness of 0.05 mm.

Then, 30% by mass of xylene was added to the composition 1-C to prepare a coating liquid. The coating liquid was coated on one surface of the support layer (X) with a Komma coater at a coating speed of 0.5 m/min. The oven temperature was set to 80°C/80°C/150°C/150°C, and heating was performed for 15 minutes in total to obtain a laminate including the cured product of the composition 1-C as a silicone rubber layer (Y) on the support layer (X).

Subsequently, the composition 2-B was coated on the surface of the silicone rubber layer (Y). Press molding was performed at 120°C for 10 minutes to cure the composition 2-B to obtain a thermally conductive silicone composite sheet composed of the support layer (X), the silicone rubber layer (Y), and the cured product of the composition 2-B as a silicone rubber layer (Z) laminated in this order.
X: 0.05 mm, Y: 0.15 mm, Z: 1.3 mm, total thickness: 1.5 mm

### (Working example 6)

A glass cloth filler solution was obtained by adding 60% by mass of xylene to the composition 1-B. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 120°C for 10 minutes to obtain a support layer (X) having a thickness of 0.05 mm.

Then, 20% by mass of xylene was added to the composition 1-B to prepare a coating liquid. The coating liquid was coated on one surface of the support layer (X) with a Komma coater at a coating speed of 0.5 m/min. The oven temperature was set to 80°C/80°C/150°C/150°C, and heating was performed for 15 minutes in total to obtain a laminate including the cured product of the composition 1-B as a silicone rubber layer (Y) on the support layer (X).

Meanwhile, a toluene solution of 1% by mass of dimethylpolysiloxane capped at both ends with trimethylsiloxy (number of dimethylsiloxane units: 38) was prepared as a primer. The primer was applied to the surface of the silicone rubber layer (Y) of the laminate using a gravure coater and was dried at 80°C to obtain a dimethylpolysiloxane-treated silicone rubber layer (Y').

Subsequently, the composition 2-B was coated on the surface of the silicone rubber layer (Y'). Press molding was performed at 120°C for 10 minutes to cure the composition 2-B to obtain a thermally conductive silicone composite sheet composed of the support layer (X), the silicone rubber layer (Y), silicone rubber layer (Y'), and the cured product of the composition 2-B as a silicone rubber layer (Z) laminated in this order.
X: 0.05 mm, Y + Y': 0.15 mm (the same applies to Table 3), Z: 0.8 mm, total thickness: 1.0 mm

### (Comparative example 1)

A coating liquid was prepared by adding 20% by mass of xylene solution to the composition 1-A. The coating liquid was coated on one surface of a fluorine-treated PET film (FL-1-01 (Takara Incorporation)) having a thickness of 50 µm with a Komma coater at a coating speed of 0.5 m/min. The oven temperature was set to 60°C/60°C/60°C/60°C, and heating was performed for 15 minutes in total to obtain a laminate including an uncured silicone rubber layer of the composition 1-A on the base material. Glass cloth was laminated to this uncured silicone rubber layer at a pressure of 0.1 MPa, and the resulting laminate was immersed in the coating liquid to impregnate the glass cloth with the coating liquid. Subsequently, a fluorine-treated PET film (FL-1-01 (Takara Incorporation)) was further laminated to the coated surface.

Subsequently, the composition 2-A was coated on the surface of the laminated fluorine-treated PET film, and press molding was performed at 120°C for 10 minutes to cure the composition 2-A to obtain a thermally conductive silicone composite sheet.
X: 0.05 mm, Y: 0.15 mm, Z: 0.8 mm, total thickness: 1.0 mm

### (Comparative example 2)

A composition 1-B' was prepared as in the composition 1-B except that the component (B), the component (C), and the component (F) were not added and that 1.5 parts of PERHEXA 25B (manufactured by NOF Corporation) was added as a vulcanizing agent. A glass cloth filler solution was obtained by adding 60% by mass of xylene to this composition 1-B'. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 150°C for 10 minutes to obtain a support layer (X) having a thickness of 0.05 mm.

Then, 20% by mass of xylene was added to the composition 1-B' to prepare a coating liquid. The coating liquid was coated on one surface of the support layer (X) with a Komma coater at a coating speed of 0.5 m/min. The oven temperature was set to 80°C/80°C/150°C/150°C, and heating was performed for 15 minutes in total to obtain a laminate including the cured product of the composition 1-B' as a silicone rubber layer (Y) on the support layer (X).

Subsequently, the composition 2-B was coated on the surface of the silicone rubber layer (Y). Press molding was performed at 120°C for 10 minutes to cure the composition 2-B to obtain a thermally conductive silicone composite sheet composed of the support layer (X), the silicone rubber layer (Y), and the cured product of the composition 2-B as a silicone rubber layer (Z) laminated in this order.
X: 0.05 mm, Y: 0.15 mm, Z: 0.8 mm, total thickness: 1.0 mm

### (Comparative example 3)

A glass cloth filler solution was obtained by adding 80% by mass of xylene to the composition 1-A. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 120°C for 10 minutes to obtain a support layer (X) having a thickness of 0.05 mm.

Then, 20% by mass of xylene was added to the composition 1-A to prepare a coating liquid. The coating liquid was coated on one surface of the support layer (X) with a komma coater at a coating speed of 0.5 m/min. The oven temperature was set to 80°C/80°C/150°C/150°C, and heating was performed for 15 minutes in total to obtain a laminate including the cured product of the composition 1-A as a silicone rubber layer (Y) on the support layer (X).

Subsequently, the composition 2-A was coated on the other surface, not having the silicone rubber layer (Y), of the support layer (X) of the laminate, and press molding was performed at 120°C for 10 minutes to cure the composition 2-A to obtain a thermally conductive silicone composite sheet composed of the silicone rubber layer (Y), the support layer (X), and the cured product of the composition 2-A as a silicone rubber layer (Z) laminated in this order.
X: 0.05 mm, Y: 0.15 mm, Z: 0.15 mm, total thickness: 0.35 mm

### (Comparative example 4)

A glass cloth filler solution was obtained by adding 80% by mass of xylene to the composition 1-A. The filler solution was put in a container having a capacity large enough to accommodate glass cloth. Subsequently, the glass cloth was placed in the container and was immersed in the filler solution to be impregnated with the filler solution. Once the glass cloth was impregnated with the filler solution at room temperature for 5 minutes, the cloth was then continuously pulled up to remove excess filler solution from the glass cloth. The glass cloth was then put in an oven, dried at 80°C for 10 minutes, and cured at 120°C for 10 minutes to obtain a filled glass cloth having a thickness of 0.05 mm.

Then, 20% by mass of xylene was added to the composition 1-A to prepare a coating liquid. The coating liquid was coated on one surface of the filled glass cloth with a komma coater at a coating speed of 0.5 m/min. The oven temperature was set to 80°C/80°C/150°C/150°C, and heating was performed for 15 minutes in total to obtain a laminate including the cured product of the composition 1-A as a silicone rubber layer (Y) on the filled glass cloth.

Subsequently, the composition 2-C was coated on the other surface, not having the silicone rubber layer (Y), of the filled glass cloth layer of the laminate, and press molding was performed at 120°C for 10 minutes to cure the composition 2-C to obtain a thermally conductive silicone composite sheet composed of the silicone rubber layer (Y), the filled glass cloth layer, and the cured product of the composition 2-C as a silicone rubber layer (Z) laminated in this order.
X: 0.05 mm, Y: 0.15 mm, Z: 1.8 mm, total thickness: 2.0 mm

### <Evaluation of composite sheet>

### [Adhesion of high-hardness thermally conductive silicone rubber layer (Y) and low-hardness thermally conductive silicone rubber layer (Z)]

In each of the obtained thermally conductive silicone composite sheets, the low-hardness thermally conductive silicone rubber layer was peeled off from the high-hardness thermally conductive silicone rubber layer. When adhesive residue was present, it was determined as "Cohesive fracture", and separation without adhesive residue was determined as "Interfacial peeling".

### [Compression stress]

The maximum stress when each of the obtained thermally conductive silicone composite sheets was compressed by 50% at a compression rate of 0.5 mm/min using Autograph (manufactured by Shimadzu Corporation) was measured.

### [Oil bleeding]

Each of the obtained thermally conductive silicone composite sheets was cut into a disk with a diameter of 13 mm. The disk was placed on frosted glass, compressed by 50% using a compression jig, and then subjected to aging at 100°C for 100 hours in the compressed state. After completion of the aging, the compression was released, and the width (mm) of oil, oozed out from the thermally conductive silicone composite sheet onto the frosted glass, was measured.

### [Number of uses of release PET film]

The number of release PET films used before molding of the thermally conductive silicone composite sheet was recorded.

The results of Working examples 1 to 6 are shown in Table 3, and the results of Comparative examples 1 to 4 are shown in Table 4.

**[Table 3]**

| | | Working example | | | | | |
|---|---|---|---|---|---|---|---|
| | | 1 | 2 | 3 | 4 | 5 | 6 |
| X layer | Composition | 1-A | 1-B | 1-A | 1-C | 1-C | 1-B |
| | Thickness (mm) | 0.05 | 0.05 | 0.05 | 0.05 | 0.05 | 0.05 |
| Y layer | Composition | 1-A | 1-B | 1-A | 1-C | 1-C | 1-B |
| | Thickness (mm) | 0.15 | 0.10 | 0.15 | 0.15 | 0.15 | 0.15 |
| Z layer | Composition | 2-A | 2-B | 2-C | 2-A | 2-B | 2-B |
| | Thickness (mm) | 0.8 | 0.35 | 1.8 | 0.8 | 1.3 | 0.8 |
| Total thickness (mm) | | 1.0 | 0.5 | 2.0 | 1.0 | 1.5 | 1.0 |
| Adhesive state of Y layer and Z layer | | Cohesive fracture | Cohesive fracture | Cohesive fracture | Cohesive fracture | Cohesive fracture | Cohesive fracture |
| Compression stress (MPa) | | 1.05 | 1.92 | 1.67 | 0.92 | 1.28 | 2.65 |
| Oil bleeding width (mm) | | 1 | 1 | 1.5 | 1.5 | 2 | 1.5 |
| Number of uses of release PET film | | 0 | 0 | 0 | 0 | 0 | 0 |

**[Table 4]**

| | | Comparative example | | | |
|---|---|---|---|---|---|
| | | 1 | 2 | 3 | 4 |
| X layer | Composition | None | 1-B' | 1-A | 1-A |
| | Thickness (mm) | None | 0.05 | 0.05 | 0.05 |
| Y layer | Composition | 1-A | 1-B' | 1-A | 1-A |
| | Thickness (mm) | 0.2 | 0.1 | 0.15 | 0.15 |
| Z layer | Composition | 2-A | 2-B | 2-A | 2-C |
| | Thickness (mm) | 0.8 | 0.35 | 0.15 | 1.8 |
| Total thickness (mm) | | 1.0 | 0.5 | 0.35 | 2.0 |
| Adhesive state of Y layer and Z layer | | Interfacial peeling | Interfacial peeling | Cohesive fracture | Interfacial peeling |
| Compression stress | | 1.24 | 2.45 | 8.21 | 1.57 |
| Oil bleeding width (mm) | | 3 | 6.5 | 3.5 | 3 |
| Number of uses of release PET film | | 2 | 0 | 0 | 0 |

As can be seen from Tables 3 and 4, in Working example 1 to 5, it is possible to provide a thermally conductive silicone composite sheet that exhibits good adhesion and compression properties without using a release PET film and has reliability for oil bleeding.

In contrast, in Comparative example 1, when a high-hardness thermally conductive silicone rubber layer was molded, a release PET film was used twice, and there were problems that the cost is increased and that an additional peeling process by a user is required.

In Comparative example 2, since a peroxide vulcanization system was employed to prepare the high-hardness thermally conductive silicone rubber layer, adhesion with the low-hardness thermally conductive silicone rubber layer was not good, and also oil bleeding was significantly increased.

In Comparative examples 3 and 4, a mesh reinforcement filled with a thermally conductive material was used as an intermediate layer to mold each composite sheet.

In Comparative example 3, even though the high-hardness thermally conductive silicone rubber layer and the low-hardness thermally conductive silicone rubber layer adhered well to each other, the low-hardness thermally conductive silicone rubber layer exhibited small thickness. As a result, the compression stress under high compression increased, which was identified as a problem.

In Comparative Example 4, increasing the thermal conductivity of the low-hardness silicone rubber layer caused interfacial peeling, which was identified as a problem.

## Claims

1. A thermally conductive silicone composite sheet comprising, laminated in the following order:
a support layer (X),
a high-hardness thermally conductive silicone rubber layer (Y), and
a low-hardness thermally conductive silicone rubber layer (Z),
wherein the support layer (X) is composed of a mesh reinforcement filled with a cured product of a thermally conductive composition, and
wherein the high-hardness thermally conductive silicone rubber layer (Y) and the low-hardness thermally conductive silicone rubber layer (Z) are each a cured product of an addition-curable silicone rubber composition, and the high-hardness thermally conductive silicone rubber layer (Y) has a hardness of 50 to 97 as measured by a method described in JIS K6253-1: 2012 using a Shore A hardness tester, and the low-hardness thermally conductive silicone rubber layer (Z) has a hardness of 2 to 30 as measured by a method described in JIS K7312: 1996 using an Asker C hardness tester.

2. The thermally conductive silicone composite sheet according to claim 1, wherein the mesh reinforcement is glass cloth.

3. The thermally conductive silicone composite sheet according to claim 1, wherein the high-hardness thermally conductive silicone rubber layer (Y) is a cured product of an addition-curable silicone rubber composition comprising the components (A1) to (D1) defined as:
(A1) an organopolysiloxane containing two or more alkenyl groups per molecule and having an average polymerization degree of 100 to 20,000 in an amount of 100 parts by mass;
(B1) an organohydrogen polysiloxane containing two or more hydrosilyl groups per molecule in an amount such that a ratio of the number of moles of hydrosilyl groups in the component (B1) to the number of moles of alkenyl groups in the component (A1) is 1.0 to 3.5;
(C1) a platinum-group metal catalyst in an amount of 0.1 to 1,000 ppm in terms of the mass of the platinum-group metal; and
(D1) a thermally conductive filler in an amount of 300 to 4,000 parts by mass.

4. The thermally conductive silicone composite sheet according to claim 3, wherein the addition-curable silicone rubber composition contains (E1) a dimethylpolysiloxane having one end of the molecular chain blocked by a trialkoxy group, wherein the dimethylpolysiloxane serves as a surface-treatment agent and is represented by formula (2): 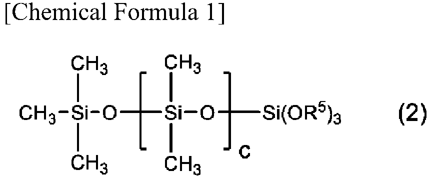 wherein R⁵s are each independently an alkyl group having 1 to 6 carbon atoms, and c is a number from 4 to 100.

5. The thermally conductive silicone composite sheet according to claim 1, wherein the thermally conductive composition constituting the layer (X) is the same as the thermally conductive silicone rubber composition constituting the high-hardness thermally conductive silicone rubber layer (Y).

6. The thermally conductive silicone composite sheet according to claim 1, wherein the low-hardness thermally conductive silicone rubber layer (Z) is a cured product of an addition-curable silicone rubber composition comprising the components (A2) to (E2) defined as:
(A2) an organopolysiloxane containing two or more alkenyl groups per molecule and having an average polymerization degree of 100 to 2,000 in an amount of 100 parts by mass;
(B2) an organohydrogen polysiloxane containing two or more hydrosilyl groups per molecule in an amount such that a ratio of the number of moles of hydrosilyl groups in the component (B2) to the number of moles of alkenyl groups in the component (A2) is 0.5 to 1.5;
(C2) a platinum-group metal catalyst in an amount of 0.1 to 1,000 ppm in terms of the mass of the platinum-group metal;
(D2) a thermally conductive filler in an amount of 500 to 4,000 parts by mass; and
(E2) a dimethylpolysiloxane having one end of the molecular chain blocked by a trialkoxy group in an amount of 10 to 300 parts by mass, wherein the dimethylpolysiloxane serves as a surface-treatment agent and is represented by formula (2): 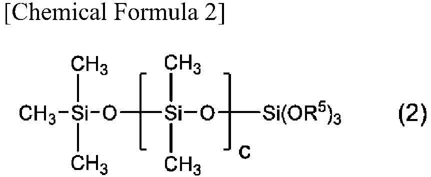 wherein R⁵s are each independently an alkyl group having 1 to 6 carbon atoms, and c is a number from 4 to 100.

7. The thermally conductive silicone composite sheet according to claim 1, wherein the high-hardness thermally conductive silicone rubber layer (Y) has a thickness of 0.15 to 0.5 mm, and the thermally conductive silicone composite sheet has an overall thickness of 0.3 to 10 mm.

8. The thermally conductive silicone composite sheet according to claim 1, wherein the support layer (X) has a thickness of 0.03 to 0.10 mm.
